# EUROPEAN PATENT APPLICATION

(11) **EP 2 755 240 A1**
(43) Date of publication of application: **16.07.2014**
(21) Application number: 14150381.3
(22) Date of filing: 07.01.2014
(51) Int. Cl.: H01L 31/0224, H01L 27/142, H01L 31/0392, H01L 31/18, H01L 31/032, H01L 31/0749, H01L 21/268

(54) **Method for manufacturing solar cell**

(30) Priority: 10.01.2013 US 201361751207 P; 22.11.2013 US 201314088296
(71) Applicant: Samsung SDI Co., Ltd., Yongin-si, Gyeonggi-do (KR)
(72) Inventor: Kim, Min-Sung, Gyeonggi-do (KR); Kim, Min-Kyu, Gyeonggi-do (KR); Kim, Su-Yeon, Gyeonggi-do (KR); Nam, Yuk-Hyun, Gyeonggi-do (KR); Kang, Ku-Hyun, Gyeonggi-do (KR)
(74) Representative: Mounteney, Simon James

(57) **Abstract**

A method of manufacturing a solar cell module, the said method comprising: providing a first substrate having a first surface that faces in a first direction; providing a first electrode layer having a first surface that faces in the first direction over the first surface of the first substrate; removing a portion of the first electrode using a first laser beam in order to expose a corresponding portion of the first surface of the substrate; providing a light absorption layer having a first surface that faces in the first direction over the first surface of the first electrode; removing a portion of the light absorption layer using a second laser beam in order to expose a corresponding portion of the first surface of the first electrode; providing a second electrode layer having a first surface that faces in the first direction over the first surface of the light absorption layer; and removing a portion of the second electrode layer using a third laser beam in order to expose a corresponding portion of the first surface of the light absorption layer; wherein the second and third laser beams are applied in the first direction from a side of the first substrate that is located on an opposite side thereof to its said first surface.

## Description

### BACKGROUND OF THE INVENTION

### (a) Field of the Invention

The present invention relates to a method for manufacturing a solar cell, and in particular, it relates to a method for manufacturing a solar cell including electrically accessing a plurality of unit cells by using a patterning process.

### (b) Description of the Related Art

In order to make a solar cell into a module, a process for identifying an electrode and a light absorbing layer formed on a substrate for a plurality of unit cells and accessing the unit cells in series is required. Electrodes and the light absorbing layer must be appropriately patterned so that the unit cells are respectively divided and electrically accessed with each other, and in this instance, the patterning process should not deteriorate a characteristic of the completed solar cell or cause damage to a component such as a lower electrode provided between a substrate and a light absorbing layer.

The above information disclosed in this Background section is only for enhancement of understanding of the background of the invention, and therefore it may contain information that does not form the prior art.

### SUMMARY OF THE INVENTION

The present invention has been made in an effort to provide a method for manufacturing a solar cell that minimizes damage to an electrode when a module of the solar cell is configured by patterning the electrode and the light absorbing layer configuring the solar cell.

A method for manufacturing a solar cell according to the invention therefore provides that, when a plurality of unit cells are formed on the substrate, damage to the electrode configuring the unit cell is prevented and the unit cells are divided in a uniform state, thereby preventing deterioration of efficiency of the manufactured solar cell.

Further, other patterns can be patterned by using the same laser beams so the method is advantageous for reducing production costs.

### BRIEF DESCRIPTION OF THE DRAWINGS

FIG. 1 shows a cross-sectional view of a configuration of a solar cell according to an embodiment of the present invention.
FIG. 2 to FIG. 7 show cross-sectional views for describing a process for manufacturing a solar cell according to an embodiment of the present invention.
FIG. 8 shows an image of a third pattern manufactured according to an embodiment of the present invention.
FIG. 9 shows an image of a third pattern according to a comparative example.

### DETAILED DESCRIPTION OF THE EMBODIMENTS

The present invention will be described more fully hereinafter with reference to the accompanying drawings, in which embodiments of the invention are shown. As those skilled in the art would realize, the described embodiments may be modified in various different ways, all without departing from the scope of the present invention.

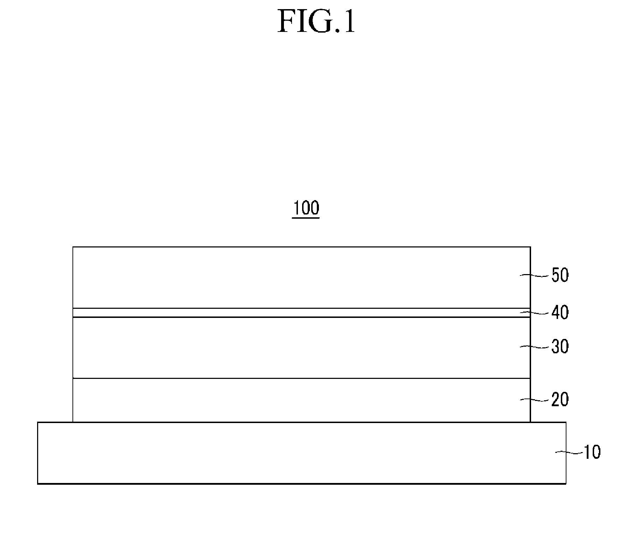

FIG. 1 shows a cross-sectional view of a configuration of a solar cell according to an embodiment of the present invention.

Referring to 1, the solar cell 100 includes a substrate 10, a lower electrode (or opaque electrode) 20, a light absorbing layer 30, a buffer layer 40, and an upper electrode (or transparent electrode) 50.

The solar cell 100 can be a compound semiconductor solar cell including CIS (Cu, In, and Se) or CIGS (Cu, In, Ga, and Se) for the light absorbing layer 30. The light absorbing layer 30 including the CIS or the CIGS will be exemplified hereinafter.

The substrate 10 is provided at the outermost side of the solar cell 100. That is, the substrate 10 is provided farthest from the side to which the sunlight is applied. The substrate 10 can be formed with various materials including plate-type glass, ceramic, stainless steel, metal, or film-type polymers.

The lower electrode 20 is provided on the substrate 10. The lower electrode 20 is made of a metal with excellent optical reflective efficiency and adhesion to the substrate 10. For example, the lower electrode 20 may include molybdenum (Mo). The molybdenum (Mo) has high electrical conductivity, forms an ohmic contact with the light absorbing layer 30, and realizes great stability during a high temperature heat treatment for forming the light absorbing layer 30.

The light absorbing layer (or photoelectric conversion layer) 30 is provided on the lower electrode 20. The light absorbing layer 30 generates electrons and holes by using light energy having been transmitted through the upper electrode 50 and the buffer layer 40. The light absorbing layer 30 can include a chalcopyrite-based compound semiconductor selected from a group consisting of CuInSe, CuInSe₂, CuInGaSe, and CuInGaSe₂.

For example, the light absorbing layer 30 can be manufactured by performing a first process ① for forming a precursor layer by sputtering copper

(Cu) and indium (In), or copper (Cu), indium (In), and gallium (Ga) on the lower electrode 20, a second process ② for thermally depositing selenium (Se) on the precursor layer, and a third process ③ for growing CIS (Cu, In, and Se) or CIGS (Cu, In, Ga, and Se) crystals by performing a fast heat treatment for over one minute at a high temperature that is greater than 550 °C. In this instance, part of selenium (Se) can be substituted with sulfur (S) so as to prevent evaporation of selenium (Se) during the fast heat treatment process. In this case, an open voltage of the solar cell 100 can be increased by increasing an energy band gap of the light absorbing layer 30.

The buffer layer 40 is provided on the light absorbing layer 30. The buffer layer 40 alleviates an energy band gap difference between the light absorbing layer 30 and the upper electrode 50. Also, the buffer layer 40 eases a lattice constant difference between the light absorbing layer 30 and the upper electrode 50 to bond the two layers 30 and 50. The buffer layer 40 includes one of cadmium sulfide (CdS), zinc sulfide (ZnS), and indium oxide (In₂O₃). The buffer layer 40 can be omitted if necessary.

The upper electrode 50 is provided on the buffer layer 40. The upper electrode 50 can be formed with a metal oxide including boron doped zinc oxide (BZO) with excellent light transmittivity, zinc oxide (ZnO), indium oxide (In₂O₃), and indium tin oxide (ITO). The upper electrode 50 has great electrical conductivity and great light transmittivity. The upper electrode 50 can form rough protrusions and depressions on the surface through an additional texturing process. In addition, an antireflection layer (not shown) can be further formed on the upper electrode 50. Formation of the surface protrusions and depressions and the antireflection layer of the upper electrode 50 reduces reflection of external light to increase sunlight transmitting efficiency toward the light absorbing layer 30.

The lower electrode 20, the light absorbing layer 30, the buffer layer 40, and the upper electrode 50 are identified by a plurality of cells on the substrate 10, and they are electrically connected with each other to form a module of the solar cell.

A method for manufacturing a solar cell according to an embodiment of the present invention will now be described.

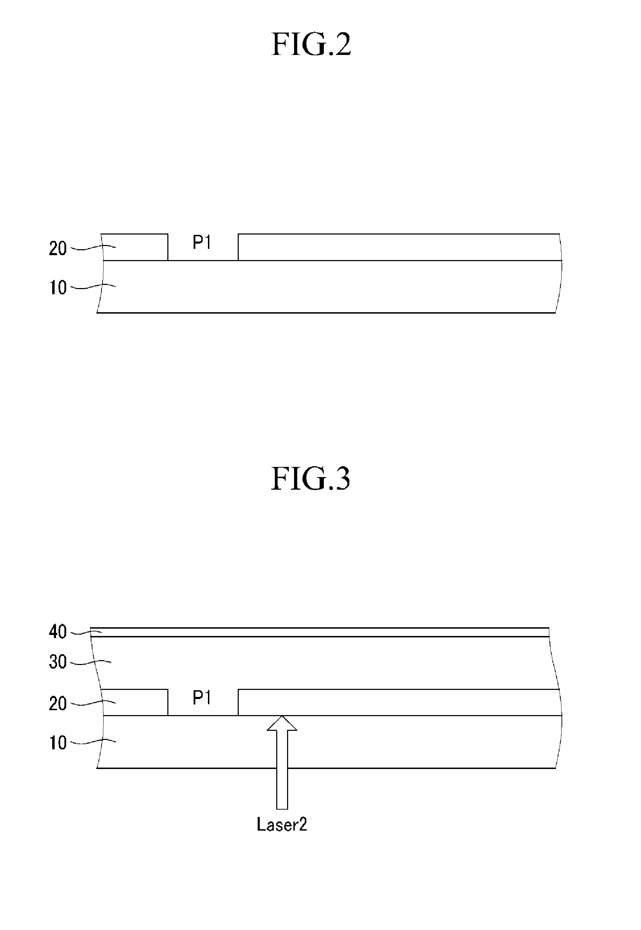

A lower electrode 20 is formed on a first side of the substrate 10 with a predetermined thickness through a predetermined method such as sputtering, and it is then divided into a plurality of smaller ones. That is, the lower electrode 20 is patterned at a predetermined position and is divided into a plurality of smaller ones by a dividing means such as first laser beams (Laser 1) (not shown.) A first pattern (P1) (refer to FIG. 2) is formed in the division of the lower electrode 20.

A light absorbing layer 30 and a buffer layer 40 are formed with a predetermined thickness on the lower electrode 20. The light absorbing layer 30 is filled at the top of the lower electrode 20 and at the first pattern (P1) (refer to FIG. 3) between the lower electrode 20 and the lower electrode 20.

A second patterning process is performed for the light absorbing layer 30 and the buffer layer 40. As shown in FIG. 3, the second patterning process for the light absorbing layer 30 and the buffer layer 40 is performed by second laser beams (Laser 2) provided to the substrate 10 in a direction that is opposite a direction that heads to the light absorbing layer 30 and the buffer layer 40.

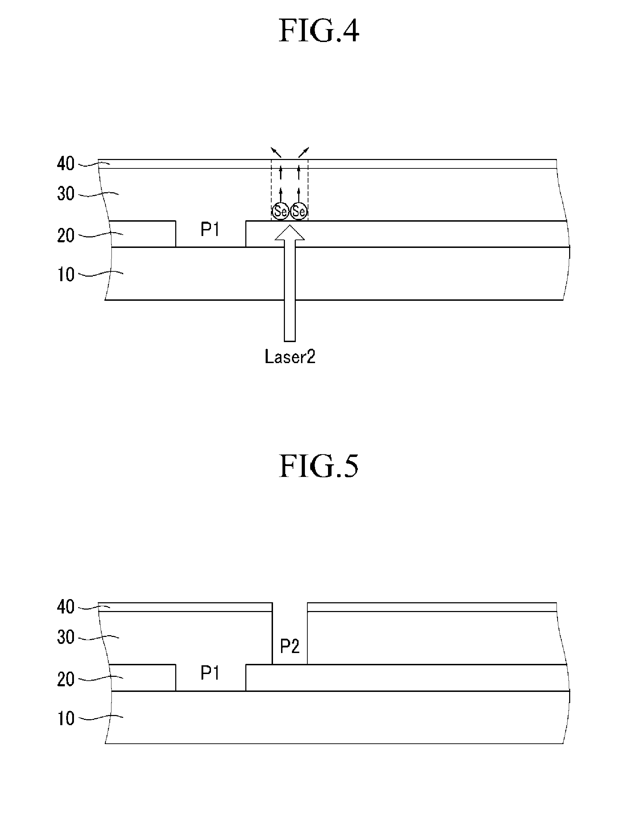

When the second patterning process is performed on the light absorbing layer 30 and the buffer layer 40 by using the second laser beams (Laser 2) provided to the substrate 10, the lower electrode 20 is heated by the laser beams, selenium (Se) or sulfur (S) is vaporized from an interface between the lower electrode 20 and the light absorbing layer 30, and the light absorbing layer 30 can be lifted off from the lower electrode 20 according to a pressure generated by the vaporization (refer to FIG. 4).

In this embodiment, the second patterning is performed by using the vaporization of selenium (Se) caused by heat energy of the laser beams. Therefore, it is desirable for the second laser beams (Laser 2) for the second patterning to have appropriate energy that does not ablate the lower electrode 20 and induces vaporization of selenium (Se.) The Se or S can be provided in a vaporization layer formed between the lower electrode and the light absorbing layer. Here, the MoSe₂ layer can be 50 to 200Å thick.

Further, vaporization of selenium (Se) can use a vaporization layer in the form of a MoSe₂ layer.

According to the interface reaction, the second patterning process can be performed without damaging the lower electrode 20 and can prevent any of the light absorbing layer 30 from remaining at the lower electrode 20.

Therefore, as shown in FIG. 5, the light absorbing layer 30 and the buffer layer 40 can be divided into a plurality of smaller ones according to the second pattern (P2) formed at the predetermined position.

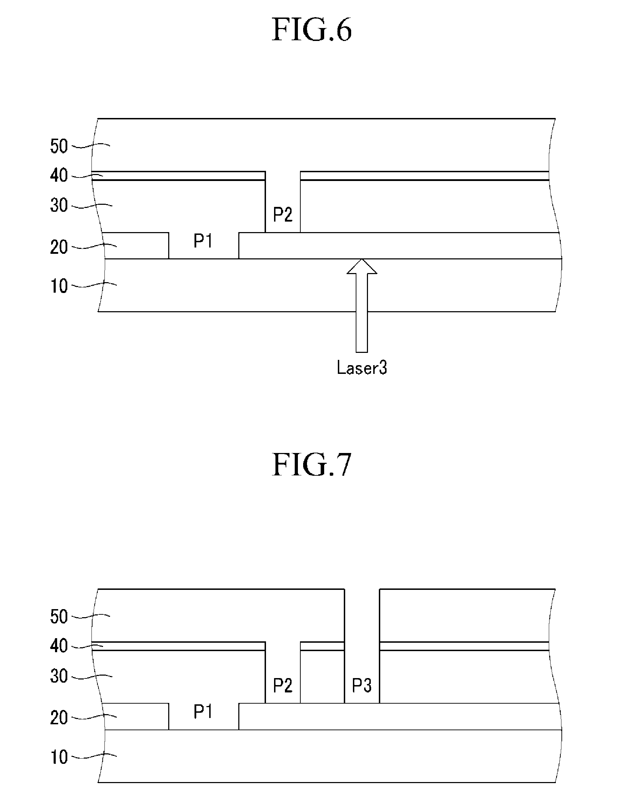

An upper electrode 50 is formed with a predetermined thickness on the buffer layer 40. The upper electrode 50 is filled on the top side of the buffer layer 40 and the second pattern (P2) (refer to FIG. 6) between the light absorbing layer 30/the buffer layer 40 and the light absorbing layer 30/the buffer layer 40.

A third patterning process is performed on the light absorbing layer 30, the buffer layer 40, and the upper electrode 50. As shown in FIG. 6, in a like manner of the second patterning process, a third patterning process is performed by third laser beams (Laser 3) provided from the substrate 10. For the third laser beams (Laser 3) for the third patterning process, the same laser beams as the second laser beams (Laser 2) for the second patterning process are usable.

By irradiation of the third laser beams (Laser 3), an interface reaction is generated at the interface of the lower electrode 20 and the light absorbing layer 30 on the third patterning part in a like manner of the second patterning process, the light absorbing layer 30 is lifted off from the lower electrode 20, and in addition, the light absorbing layer 30, the buffer layer 40, and the upper electrode 50 are removed, and a third pattern (P3) is formed on the substrate 10 (refer to FIG. 7).

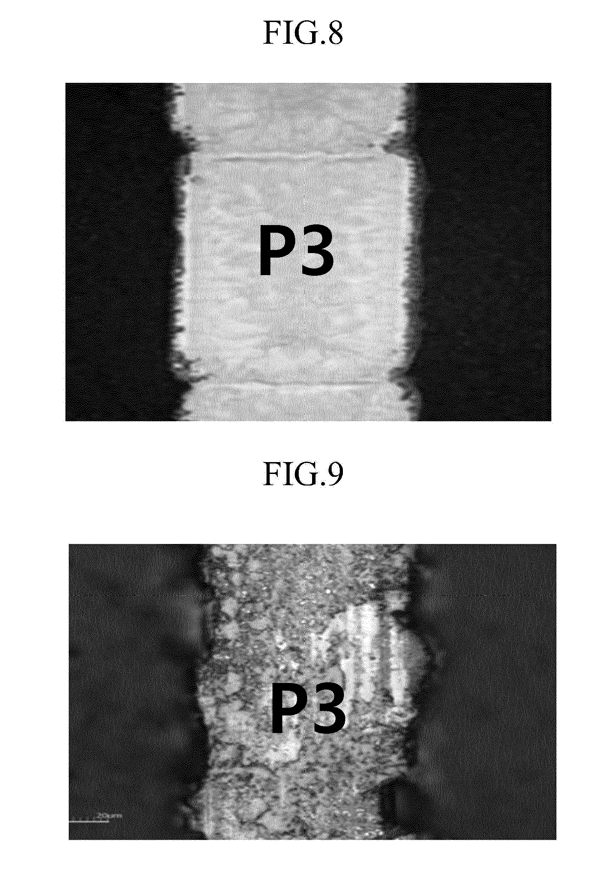

FIG. 8 shows an image of a third pattern formed using a method according to a preferred embodiment of the present invention and FIG. 9 shows an image of a third pattern according to a comparative example.

The comparative example shows the case in which the third pattern is formed by using a mechanical tool such as a cutting wheel or a knife from not the substrate but the upper electrode.

As can be known from both images, the preferred embodiment forms smooth edges of the patterned pattern compared to the comparative example.

Further, it is checked that no film is left on the lower electrode without ablating the lower electrode.

Through the above-described processes, a plurality of unit cells for the solar cell are electrically accessed in series on the substrate 10.

While certain embodiments of the present invention have been described, it is to be understood that the invention is not limited thereto, but is intended to cover various modifications and equivalent arrangements included within the scope of the appended claims, description, and drawings.

## Claims

1. A method of manufacturing a solar cell module, the said method comprising:
providing a first substrate having a first surface that faces in a first direction;
providing a first electrode layer having a first surface that faces in the first direction over the first surface of the first substrate;
removing a portion of the first electrode using a first laser beam in order to expose a corresponding portion of the first surface of the substrate;
providing a light absorption layer having a first surface that faces in the first direction over the first surface of the first electrode;
removing a portion of the light absorption layer using a second laser beam in order to expose a corresponding portion of the first surface of the first electrode;
providing a second electrode layer having a first surface that faces in the first direction over the first surface of the light absorption layer; and
removing a portion of the second electrode layer using a third laser beam in order to expose a corresponding portion of the first surface of the light absorption layer;
wherein the second and third laser beams are applied in the first direction from a side of the first substrate that is located on an opposite side thereof to its said first surface.

2. A method according to claim 1, comprising
providing a buffer layer having a first surface that faces in the first direction over the first surface of the light absorption layer prior to providing the second electrode layer;
wherein the third laser beam removes a corresponding portion of the buffer layer when removing the said portion of the second electrode layer.

3. A method according to claim 1 or 2, wherein the first electrode layer is a lower electrode layer and the second electrode layer is an upper electrode layer.

4. A method according to any preceding claim, wherein the first electrode layer is opaque.

5. A method according to claim 4, wherein the first electrode layer comprises molybdenum.

6. A method according to any preceding claim, wherein the second electrode layer is transparent.

7. A method according to claim 6, wherein the second electrode layer comprises a metal oxide.

8. A method according to claim 7, wherein the second electrode layer comprises boron doped zinc oxide (BZO), zinc oxide (ZnO), indium oxide (In₂O₃), or indium tin oxide (ITO).

9. A method according to any preceding claim, wherein the light absorbing layer comprises CIS or CIGS.

10. A method according to claim 9, wherein the light absorbing layer comprises a chalcopyrite-based compound semiconductor selected from a group consisting of CuInSe, CuInSe₂, CuInGaSe, and CuInGaSe₂.

11. A method according to claim 9 or 10, comprising forming a precursor layer by sputtering copper (Cu) and indium (In), or copper (Cu), indium (In), and gallium (Ga) on the first electrode layer prior to providing the light absorption layer.

12. A method according to any preceding claim, comprising providing a vaporization layer including selenium or sulphur between the electrode layer and the light absorbing layer.

13. A method according to Claim 12, wherein the vaporization layer comprises MoSe₂.

14. A method according to Claim 13, wherein the vaporization layer is 50 to 200A thick.

15. A method according to one of claims 11 to 14, wherein selenium or sulphur is vaporised from an interface between the first electrode layer and the light absorbing layer during the application of the second laser beam and/or the third laser beam.

16. A method according to claim 15, wherein a pressure generated by the said vaporisation is used to remove the said portion of the light absorbing layer.

17. A method according to any preceding claim, wherein the second and third laser beams are substantially the same.
